# EUROPEAN PATENT APPLICATION

(11) **EP 2 096 757 A1**
(43) Date of publication of application: **02.09.2009**
(21) Application number: 09152420.7
(22) Date of filing: 09.02.2009
(51) Int. Cl.: H03K 17/10

(54) **High voltage control switch**

(30) Priority: 26.02.2008 US 31568 P; 12.05.2008 US 119305
(71) Applicant: Honeywell International Inc., Morristown, NJ 07962 (US)
(72) Inventor: Abdelli, Said, Morristown, NJ 07962-2245 (US); Kriz, Jeffrey, Morristown, NJ 07962-2245 (US)
(74) Representative: Buckley, Guy Julian

(57) **Abstract**

A high voltage control switch including a voltage controller and a control switch is provided. The high voltage control switch splits the control switching of high voltages into two ranges. The voltage controller determines the on and off voltages appropriate for the application based on the range the input signal is in. The control switch then outputs the appropriate voltages determined by the voltage controller based on a logic input. As such, the high voltage control switch provides fast and reliable operation for high voltage switching applications.

## Description

### RELATED APPLICATIONS

This application claims priority to U.S. Provisional Patent Application No. 61/031,568, filed February 26, 2008, incorporated by reference herein.

### FIELD OF INVENTION

The present invention relates to a control circuit, more particularly, a high voltage control switch circuit.

### BACKGROUND

It is well known in the art that transistors are often used to perform standard switching functions in integrated circuits. While modern day transistors make reliable switches in many circuit applications, there are also many circuit applications that place severe operational constraints on the switch transistor. In particular, many applications require the interfacing of transistors with signals having magnitudes significantly greater than the power supply voltage for the transistor.

The interfacing of a transistor with signals having magnitudes greater than the voltage rating of the transistor puts the transistor at risk for a voltage breakdown, and also decreases the switching speed of the transistor when the channels of transistors become too narrow for the necessary current flow. Transistors with high voltage ratings exist for such applications, but are accordingly restricted to only high voltage switching applications. As such, a control switch circuit that can handle high voltage switching applications, while retaining the versatility of handling lower voltage applications is desired.

### SUMMARY

A high voltage control switch, including a high voltage controller and a control switch is provided. The high voltage control switch splits the control switching of high voltages into two ranges. The voltage controller determines the on and off voltages appropriate for the application based on the range the input signal is in. The control switch then outputs the appropriate voltages determined by the voltage controller based on a logic input.

In one embodiment, the high voltage controller comprises inverter-like circuits for the determination of both the on and the off voltages. In another embodiment, the high voltage controller comprises differential amplifier circuits. Further, alternative embodiments can be hybrids comprising both an inverter-like circuit and a differential amplifier circuit.

These features will become apparent to those of ordinary skill in the art by reading the following detailed description, with appropriate reference to the accompanying drawings.

### BRIEF DESCRIPTION OF THE DRAWINGS

Figure 1 is a circuit diagram of a high voltage control switch, according to an embodiment of the present invention.
Figure 2 is a circuit diagram of a high voltage controller, according to an embodiment of the present invention.
Figure 3 is a circuit diagram of a high voltage controller, according to an alternative embodiment of the present invention.
Figure 4 is a circuit diagram of a high voltage controller, according to an alternative embodiment of the present invention.
Figure 5 is a circuit diagram of a control switch, according to an embodiment of the present invention.
Figure 6 is a test result plot of a high voltage control switch, according to an embodiment of the present invention.

### DETAILED DESCRIPTION

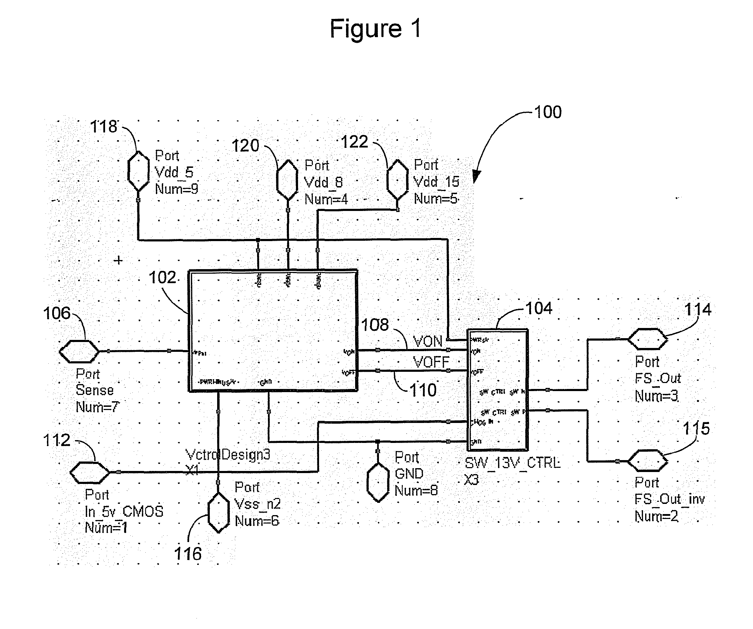

Figure 1 is a circuit diagram of a high voltage control switch 100, according to an embodiment of the present invention. The high voltage control switch 100 comprises a high voltage controller 102, a control switch 104, a sense input 106, a Von signal 108, a Voff signal 110, a logic input 112, an output 114, an inverted output 115, a -2V source 116, a 5V source 118, an 8V source 120, and a 15V source 122. The sense input 106 reads the input signal to the high voltage control switch 100. The Von signal 108 and Voff signal 110 represent the voltage used to turn a device on or off at the outputs 114 and 115. The logic input 112 is a binary signal that determines whether the device at the outputs 114 and 115 should be switched on or off. Note that the specific voltage values discussed here are simply values used in a working model of an exemplary embodiment of the present invention, which has been designed to receive input signals in the range of 0-13V. Alternative voltages can be used to adapt to different applications.

The high voltage controller 102 receives inputs from the sense input 106, the -2V source 116, the 5V source 118, the 8V source 120, and the 15V source 122, and outputs the Von signal 108 and the Voff signal 110. The control switch 104 receives inputs from the logic input 112, the 5V source 118, as well as the Von signal 108 and Voff signal 110 from the high voltage controller 102.

In operation, the high voltage controller 102 reads the sense input 106 and based on the input signal, determines the appropriate Von signal 108 and Voff signal 110. In the working model of the present invention presented here, if the sense input 106 is greater than 5V, the high voltage controller 102 will use the 15V source 122 for the Von signal 108, and the 5V source 118 for the Voff signal 110. The choice of using the 15V source 122 for the Von signal 108 when the input signal at the sense input 106 has a maximum of 13V is not arbitrary. A 15V source 122 is selected because it is sufficiently higher than 13V without entering a voltage breakdown stage. The 5V source 118 is selected for the Voff signal 110 because while it is not lower than 5V, it is sufficiently low. This is because the threshold voltage for the sense input 106 is 5V such that if the input signal is greater than 5V, a 5V Voff signal will be sufficiently low to switch the device off.

On the other hand, when the sense input 106 is less than 5V, the high voltage controller 102 will use the 8V source 120 for the Von signal 108, and the -2V source 116 for the Voff signal 110. This is so the Von signal 108 will be sufficiently greater than 5V, and the Voff signal 110 will be sufficiently low while avoiding issues resulting from current leakage.

The Von signal 108 and Voff signal 110 are received by the control switch 104. The control switch 104 reads the logic input 112 and, depending on whether the logic input 112 indicates switching the device on or off, provides the outputs 114 and 115 with the Von signal 108 or the Voff signal 110.

Based on the high voltage control switch 100 described above, there are four possible outputs based on two binary inputs. If the sense input 106 is greater than 5V and the logic input 112 indicates "on," the output 114 will be 15V. If the sense input 106 is greater than 5V and the logic input 112 indicates "off," the output will be 5V. If the sense input 106 is less than 5V and the logic input 112 indicates "on," the output will be 8V. And finally, if the sense input 106 is less than 5V and the logic input 112 indicates "off," the output will be -2V. Table 1 summarizes the possible input and output combinations.

**Table 1**

| | Von 108 | Voff 110 |
|---|---|---|
| Sense input 106 > 5 V | 15 V | 5 V |
| Sense Input 106 < 5V | 8 V | -2 V |

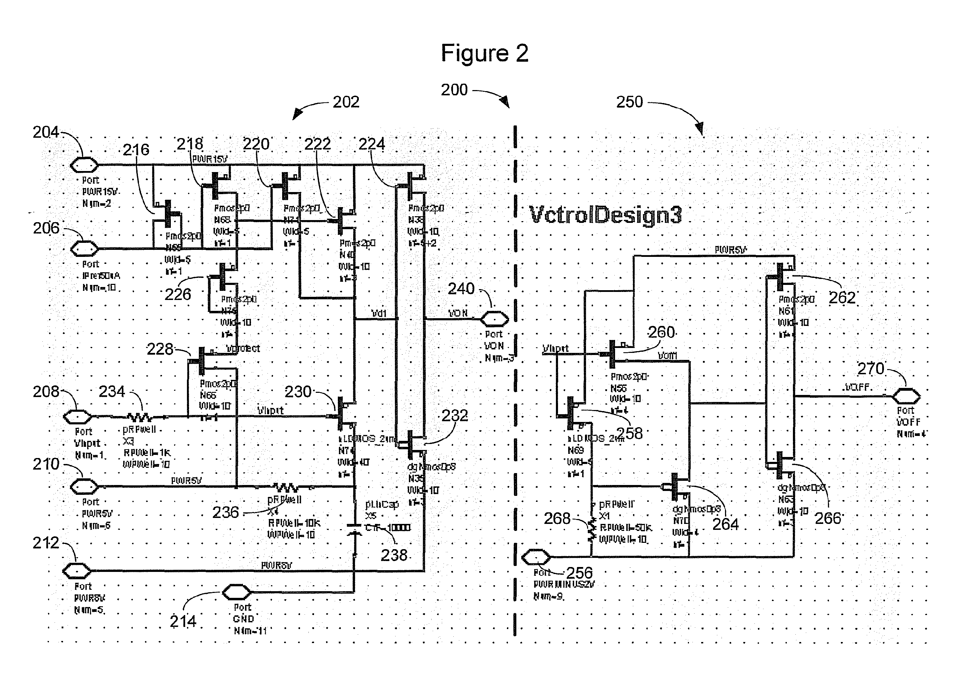

Figure 2 is a circuit diagram of a high voltage controller 200 that may be used as the high voltage controller 102 in Figure 1, according to an embodiment of the present invention. The high voltage controller circuit 200 comprises a Von controller circuit 202 and a Voff controller circuit 250. In this embodiment, both the Von controller circuit 202 and the Voff controller circuit 250 are inverter-like circuits, comprising stacked transistors.

The Von controller circuit 202 includes a 15V source 204, a current source 206, an input signal 208, a 5V source 210, an 8V source 212, and a ground source 214 as the inputs, and a Von signal 240 as the output. When referencing Figure 1, the 15V source 204 corresponds to the 15V source 122, the input signal 208 corresponds to the sense input 106, the 5V source 210 corresponds to the 5V source 118, the 8V source 212 corresponds to the 8V source 120, and the Von signal output 240 corresponds to the Von signal 108.

The Von controller circuit 202 also includes p-channel transistors 216, 218, 220, 222, 224, 226, and 228; n-channel transistors 230 and 232; resistors 234 and 236; and capacitor 238. The sources of p-channel transistors 216, 218, 220, 222 and 224 are each coupled to the 15V source 204. The gates of p-channel transistors 216, 218 and 220 are each coupled to the current source 206, as is the drain of p-channel transistor 216. The drain of p-channel transistor 218, the source of p-channel transistor 226, and the gate of p-channel transistor 222 all share a common node. The gate and drain of p-channel transistor 226 are both coupled to the source of p-channel transistor 228. The gates of p-channel transistor 228 and n-channel transistor 230 are both coupled to the input signal 208 by the resistor 234. The drain of p-channel transistor 228 is coupled to the 5V source 210, while the source of n-channel 230 is coupled to the 5V source 210 by the resistor 236 and to the ground source 214 by the capacitor 238. The drains of p-channel transistors 220, 222 and n-channel transistor 230 and the gates of p-channel transistor 224 and n-channel transistor 232 all share a common node. The source of n-channel transistor 232 is coupled to the 8V source 212, and the drains of p-channel transistor 224 and n-channel transistor 232 are both coupled to the Von signal output 240. The resistor 234 may have a resistance of approximately 1 kilo-Ohms and the resistor 236 may have a resistance of approximately 10 kilo-Ohms. The resistor 236 can alternatively be replaced by a short circuit for faster performance. The capacitor may have a capacitance of approximately 10 pico-Farads.

The Voff controller circuit 250 includes a -2V source 256 in addition to the inputs in Von controller circuit 202, and a Voff signal 270 as the output. When referencing Figure 1, the -2V source 256 corresponds to the -2V source 116, and the Voff signal output 270 corresponds to the Voff signal 110.

The Voff controller circuit 250 also includes p-channel transistors 260 and 262, n-channel transistors 258, 264, and 266, and a resistor 268. The gates of n-channel transistor 258 and p-channel transistor 260 are both coupled to the input signal 208. The drain of n-channel transistor 258 and the sources of p-channel transistors 260 and 262 are each coupled to the 5V source 210. The source of n-channel transistor 258 and the gate of n-channel transistor 264 are both coupled to the -2V source 256 by the resistor 268. The drains of p-channel transistor 260 and n-channel transistor 264 and the gates of p-channel transistor 262 and n-channel transistor 266 all share a common node. The sources of n-channel transistors 264 and 266 are both coupled to the -2V source 256 and the drains of p-channel transistor 262 and n-channel transistor 266 are both coupled to the Voff signal output 270. The resistor 268 may have a resistance of approximately 50 kilo-Ohms.

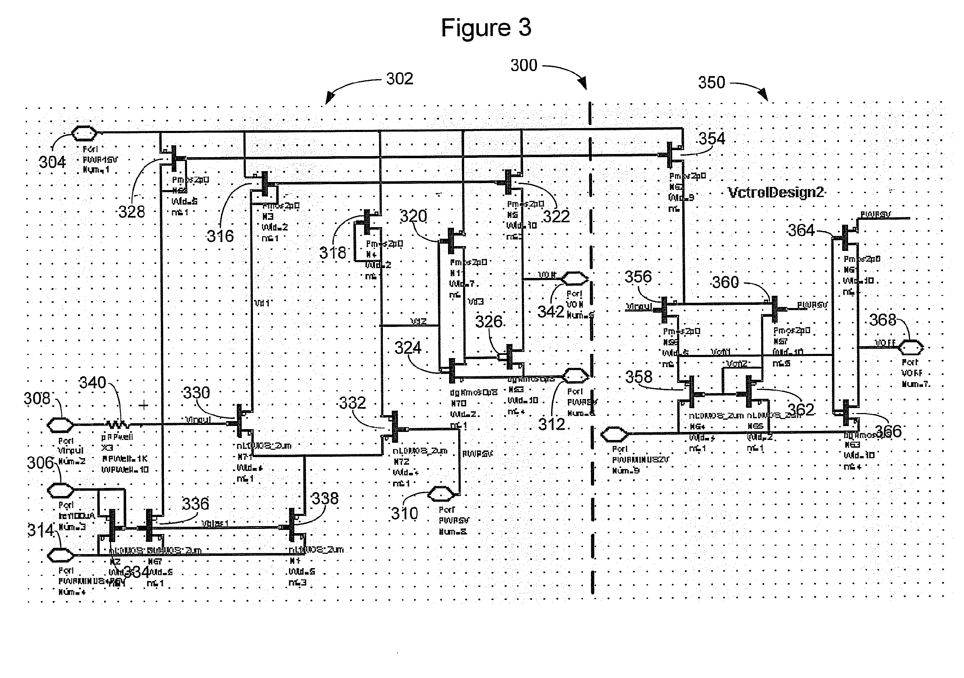

Figure 3 is a circuit diagram of a high voltage controller 300 that may be used as the high voltage controller 102 in Figure 1, according to an embodiment of the present invention. The high voltage controller circuit 300 comprises a Von controller circuit 302 and a Voff controller circuit 350. In this embodiment, both the Von controller circuit 302 and the Voff controller circuit 350 are differential amplifier circuits.

The Von controller circuit 302 includes a 15V source 304, a current source 306, an input signal 308, a 5V source 310, an 8V source 312, and a -2V source 314 as the inputs and a Von signal 342 as the output. When referencing Figure 1, the 15V source 304 corresponds to the 15V source 122, the input signal 308 corresponds to the sense input 106, the 5V source 310 corresponds to the 5V source 118, the 8V source 312 corresponds to the 8V source 120, the -2V source 314 corresponds to the -2V source 116, and the Von signal output 342 corresponds to the Von signal 108.

The Von controller circuit 302 also includes p-channel transistors 316, 318, 320, 322, and 328, n-channel transistors 324, 326, 330, 332, 334, 336 and 338, and resistor 340. The sources of p-channel transistors 328, 316 318, 320 and 322 are each coupled to the 15V source 304. The drain of p-channel transistor 328 is coupled to its gate and also to the drain of n-channel transistor 336. The gate of n-channel transistor 330 is coupled to the signal input 308 by resistor 340. The drain of the n-channel transistor 334 and the gates of n-channel transistors 334, 336 and 338 all share a common node and are coupled to the current source 306. The sources of n-channel transistors 334, 336 and 338 are all coupled to the - 2V source 314. The sources of n-channel transistors 330 and 332 and the drain of n-channel transistor 338 all share a common node. The drains of p-channel transistor 316 and n-channel transistor 330 and the gates of p-channel transistors 316 and 322 all share a common node. The drains of p-channel transistor 318 and n-channel transistor 332 and the gates of p-channel transistors 318, 320 and n-channel transistor 324 all share a common node. The drains of p-channel transistor 320 and n-channel transistor 324, and the gate of n-channel transistor 326 all share a common node. The gate of n-channel transistor 332 is coupled to the 5V source 310, the sources of n-channel transistors 324 and 326 are both coupled to the 8V source 312, and the drains of p-channel transistor 322 and n-channel transistor 326 are both coupled to the Von signal output 342. The resistor 340 may have a resistance of approximately 1 kilo-Ohms.

The Voff controller circuit 350 includes the inputs for Von controller circuit 302, and a Voff signal 368 as the output. When referencing Figure 1, the Voff signal output 368 corresponds to the Voff signal 110.

The Voff controller circuit 350 also includes p-channel transistors 354, 356, 360, and 364 and n-channel transistors 358, 362, 366. The source of p-channel transistor 354 is coupled to the 15V source 304, and the gate of p-channel transistor 356 is coupled to the input signal 308. The source of p-channel transistor 364 and the gate of p-channel transistor 360 are both coupled to the 5V source 310, and the sources of n-channel transistors 358, 362, and 366 are each coupled to the -2V source 314. The gate of p-channel transistor 354 is connected to the gate and drain of the p-channel transistor 328 in the Von controller circuit 302. The drain of p-channel transistor 354 and the sources of p-channel transistors 356 and 360 all share a common node. The gates of n-channel transistors 358 and 362, the drain of p-channel transistors 360, and the drain of n-channel transistor 362 all share a common node. The drains of p-channel transistor 356 and n-channel transistor 358 and the gates of p-channel transistor 364 and n-channel transistor 366 all share a common node. The drains of p-channel transistor 364 and n-channel transistor 366 are both coupled to the Voff signal output 368.

As mentioned before, high voltage controller circuit 200 comprises two inverter-like circuits, while high voltage controller circuit 300 comprises two differential amplifier circuits. While either of the high voltage controller circuits 200 and 300 can be used as the high voltage controller 102 in the high voltage control switch 100, each has distinct characteristics. The key difference is that the high voltage controller circuit 300 with differential amplifier circuits operates faster than, but also consumes more current than the high voltage controller circuit 200.

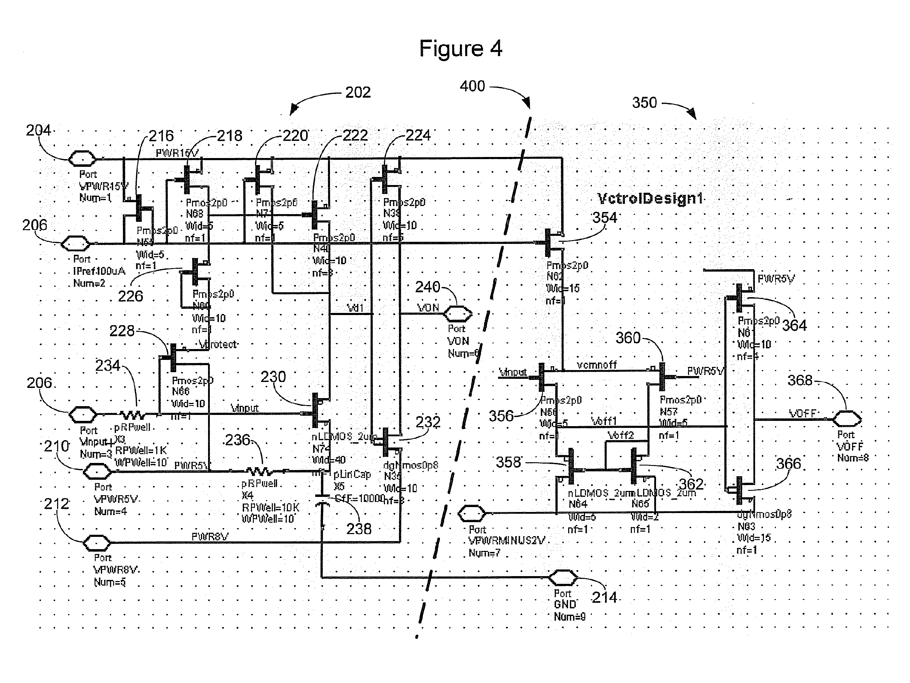

Figure 4 is a circuit diagram of a high voltage controller 400 that may be used as the high voltage controller 102 in Figure 1, according to an embodiment of the present invention. The high voltage controller circuit 400 is a hybrid between the high voltage controller circuits 200 and 300, implementing the inverter-like circuit 202 for the Von controller and the differential amplifier circuit 350 for the Voff controller. When combining the controllers, the gate of p-channel transistor 354 is coupled to the current source 206 or 306. This hybrid high voltage controller provides a compromise between operation speed and current consumption. Similarly, the use of a differential amplifier circuit for the Von controller and an inverter-like circuit for the Voff controller is feasible.

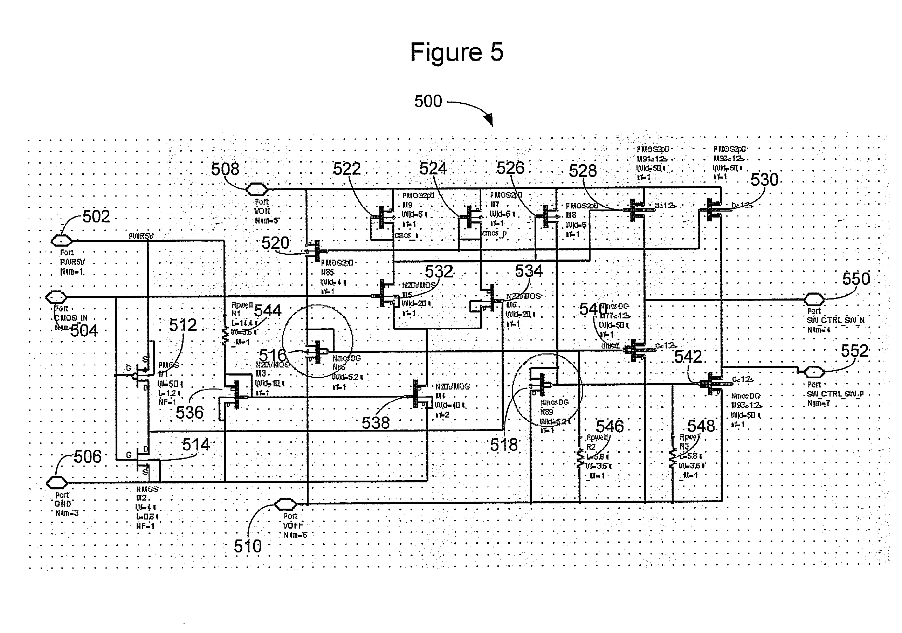

Figure 5 is a circuit diagram of a control switch 500 that may be used as the control switch 104 in Figure 1, according to an embodiment of the present invention. The control switch 500 includes a 5V source 502, a logic input 504, a ground source 506, a Von signal input 508, a Voff signal input 510, an output 550, and an inverted output 552. When referencing Figure 1, the 5V source 502 corresponds to the 5V source 118, the logic input 504 corresponds to the logic input 112, the Von signal input 508 corresponds to the Von signal 108, the Voff signal 510 corresponds to the Voff signal 110, the output 550 corresponds to the output 114, and the inverted output 552 corresponds to the inverted output 115.

The control switch 500 also includes p-channel transistors 512, 520, 522, 524, 526, 528, and 530, n-channel transistors 514, 516, 518, 532, 534, 536, 538, 540, and 542, and resistors 544, 546, and 548. The gates of p-channel transistor 512 and n-channel transistors 514 and 532 are each coupled to the logic input 504. The source and substrate of p-channel transistor 512 is coupled to the 5V source 502. The gate and drain of n-channel transistor 536 and the gate of n-channel transistor 538 share a common node and are coupled to the 5V source 502 by resistor 544. The sources and substrates of n-channel transistors 514, 536, and 538 are each coupled to the ground source 506. The drains of p-channel transistor 512 and n-channel transistor 514 are both coupled to the gate of n-channel transistor 534. The sources of p-channel transistors 520, 522, 524, 526, 528, and 530 are each coupled to the Von signal input 508. The gates of p-channel transistors 520, 524, and 530 and the drains of p-channel transistor 524 and n-channel transistor 534 all share a common node. Similarly, the gates of p-channel transistors 522, 526, and 528 and the drains of p-channel transistor 522 and n-channel transistor 532 all share a common node. The sources of n-channel transistors 516, 518, 540, and 542 are all coupled to the Voff signal input 510. The sources and substrates of n-channel transistor 532 and 534 and the drain of n-channel transistor 538 all share a common node. The drains of p-channel transistor 520 and n-channel transistor 516 and the gates of n-channel transistors 516 and 540 all share a common node and are coupled to the Voff signal input 510 by the resistor 546. Similarly, the drains of p-channel transistor 526 and n-channel transistor 518 and the gates of n-channel transistors 518 and 542 all share a common node and are coupled to the Voff signal input 510 by the resistor 548. The drains of p-channel transistor 528 and n-channel transistor 540 are both coupled to the output 550. Similarly, the drains of p-channel transistor 530 and n-channel transistor 542 are both coupled to the inverted output 552. The resistor 544 may have a resistance of approximately 50 kilo-Ohms, and the resistors 546 and 548 may each have a resistance of approximately 20 kilo-Ohms.

The voltage ratings of the transistors are optimally at least half of the intended input voltage range. In addition, when high breakdown voltage is needed, a DMOS transistor can be used. Further, a transistor package that includes a connector to the substrate is appropriate when such a connection is required.

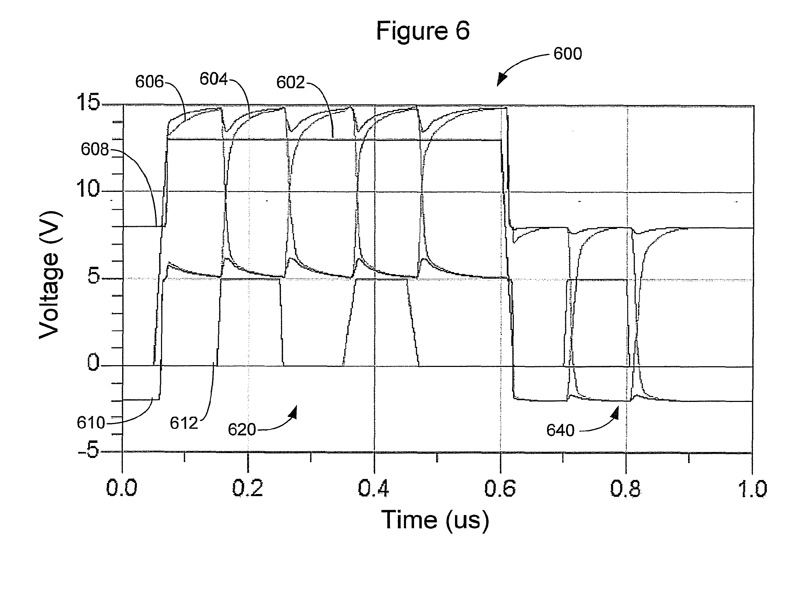

Figure 6 is a test result plot 600 of a high voltage control switch, according to an embodiment of the present invention. The plot shows the voltage versus time relationship of the different operative modes of the high voltage control switch and supports the input and output combinations shown in Table 1. The plot includes the voltage traces of an input signal 602, an output signal 604, an inverted output 606, a Von signal 608, a Voff signal 610, and a logic input 612.

The plot can be divided into two sections. A first section 620 is when the input signal 602 is greater than 5V, and a second section 640 is when the input signal 602 is less than 5V. Following the Von signal 608, we see that it rises to 15V in the first section 620 and drops to 8V in the second section 640. Similarly, the Voff signal 610 rises to 5V in the first section 620 and drops to -2V in the second section 640. In both the first section 620 and second section 640, the output 604 follows the Von signal 608 when the logic input 612 is high, and follows the Voff signal 610 when the logic input 612 is low. On the other hand, the inverted output 606 follows the Voff signal 610 when the logic input 612 is high, and follows the Von signal 608 when the logic input 612 is low.

While exemplary embodiments have been described, persons of skill in the art will appreciate that variations may be made without departure from the scope and spirit of the invention. The true scope and spirit of the invention is defined by the appended claims, which may be interpreted in light of the foregoing.

## Claims

1. A high voltage control switch comprising:
a voltage controller arranged to compare an input signal to a threshold voltage, and generate a first high voltage and a first low voltage if the input signal is greater than the threshold voltage, and generate a second high voltage and a second low voltage if the input signal is less than the threshold voltage; and
a control switch arranged to detect a logic input, and to output the generated voltages from the voltage controller in accordance with the logic input.

2. The high voltage control switch of claim 1, wherein the threshold voltage is approximately 5 volts.

3. The high voltage control switch of claim 1, wherein the first high voltage is sufficiently greater than 13 volts.

4. The high voltage control switch of claim 1, wherein the first low voltage is approximately 5 volts.

5. The high voltage control switch of claim 1, wherein the second high voltage is sufficiently greater than 5 volts.

6. The high voltage control switch of claim 1, wherein the second low voltage is sufficiently less than 0 volts.
